# EUROPÄISCHE PATENTANMELDUNG

(11) **EP 3 961 691 A1**
(43) Veröffentlichungstag der Anmeldung: **02.03.2022**
(21) Anmeldenummer: 20193009.6
(22) Anmeldetag: 27.08.2020
(51) Int. Cl.: H01L 23/00, G06K 7/10, G06K 9/00

(54) **IDENTIFIKATIONSDATENSATZ FÜR ELEKTRONISCHE BAUGRUPPEN**

(71) Anmelder: Siemens Aktiengesellschaft, 80333 München (DE)
(72) Erfinder: Blank, Rene, 12249 Berlin (DE); Frühauf, Peter, 14612 Falkensee (DE); Heimann, Matthias, 14469 Potsdam (DE); Müller, Bernd, 16259 Falkenberg (DE)

(57) **Zusammenfassung**

Die Erfindung betrifft ein computerimplementiertes Verfahren zum Erzeugen eines Identifikationsdatensatzes (ID100) für eine elektronische Baugruppe (100), wobei die Baugruppe (100) zumindest ein Substrat (110), zumindest eine Fügeverbindung (115) und zumindest ein elektronisches Bauelement (120) aufweist. Um ein vereinfachtes Verfahren zum Erzeugen eines sicheren Identifikationsdatensatzes (ID100) für elektronische Baugruppen (100) anzugeben umfasst das Verfahren die Schritte:
- Bereitstellen einer Aufnahme (100*) zumindest eines Teilbereichs der Baugruppe (100),
- Erzeugen des Identifikationsdatensatzes (ID100) auf Basis zumindest eines Teilbereichs (101*) der Aufnahme (100*).
Die Erfindung betrifft weiterhin ein Verfahren zum Herstellen einer elektronischen Baugruppe (100), eine Verwendung eines Identifikationsdatensatzes (ID100) und ein Verfahren zum Überprüfen einer elektronischen Baugruppe (100).

## Beschreibung

Die Erfindung betrifft ein Verfahren zum Erzeugen eines Identifikationsdatensatzes für eine elektronische Baugruppen, ein Verfahren zum Herstellen einer elektronischen Baugruppe, eine Verwendung eines Identifikationsdatensatzes und ein Verfahren zum Überprüfen einer elektronischen Baugruppe.

Ein derartiges Verfahren kommt beispielsweise in der Fertigung von Elektronikprodukten zum Einsatz.

Es tauchen im Markt immer wieder gefälschte Produkte auf. Außerdem können Produkte von Dritten unautorisiert modifiziert werden, was sich in Bezug auf die Sicherheit des Produkts negativ auswirkt.

Bisher wurde das Problem durch vertraute Vertriebskanäle gelöst. Weiterhin können Elektronikprodukte durch sogenannte "trusted plattform modules" (TPM) oder andere elektronische Zusatzbauteile, die z. B. unter Nutzung kryptographischer Verfahren geschützt werden. Weiterhin existieren Lösungen, die auf Aufbringen von Echtheitsmerkmalen durch z.B. Hologramme, andere Aufkleber o.ä. oder auch NanoInk, künstliche DNA etc. basieren.

Der Erfindung liegt die Aufgabe zugrunde, ein vereinfachtes Verfahren zum Erzeugen eines sicheren Identifikationsdatensatzes für elektronische Baugruppen anzugeben.

Diese Aufgabe wird durch ein Verfahren mit den im Anspruch 1 angegebenen Merkmalen gelöst.

Dazu wird ein computerimplementiertes Verfahren zum Erzeugen eines Identifikationsdatensatzes für eine elektronische Baugruppe vorgeschlagen. Die Baugruppe weist zumindest ein Substrat, zumindest eine Fügeverbindung und zumindest ein elektronisches Bauelement auf. Das Verfahren umfasst die Schritte:
- Bereitstellen einer Aufnahme zumindest eines Teilbereichs der Baugruppe,
- Erzeugen des Identifikationsdatensatzes auf Basis zumindest eines Teilbereichs der Aufnahme.

Besonders vorteilhaft an der vorliegenden Erfindung ist, dass die Aufnahme im laufenden Produktionsprozess der Baugruppe erstellt und bereitgestellt werden kann. In der Regel erstellen optische Inspektionsautomaten, wie zum Beispiel "automated optical inspection" (AOI) oder "automated X-ray inspection" (AXI), bereits solche Aufnahmen. Um diese Aufnahmen für das erfindungsgemäße Verfahren zu nutzen, können diese also direkt im Fertigungsprozess zur Verfügung gestellt werden. Der Identifikationsdatensatz ist dabei ein eindeutiger, der jeweiligen elektronischen Baugruppe zugeordneter Datensatz, der zur eindeutigen Identifikation der Baugruppe, auch nach vielen Jahren, geeignet ist.

In einer weiteren Ausführungsform umfasst das Bereitstellen der Aufnahme ein Bereitstellen einer Röntgen-Aufnahme der Baugruppe. Röntgenbilder von elektronischen Baugruppen weisen unter anderem durch die Fügeverbindungen, z. B. Lötstellen von BGA- oder QFN-Bauelementen, einzigartige Muster bzw. Merkmale auf. Es hat sich herausgestellt, dass sich die Merkmale bzw. die Kombination mehrerer solcher Merkmale als ein Fingerabdruck der elektronischen Schaltung nutzen lassen. Die Merkmale können dabei durch den Fügeprozess bedingt sein.

In einer weiteren Ausführungsform umfasst das Bereitstellen der Aufnahme ein Bereitstellen einer digitalen Aufnahme, insbesondere im sichtbaren Spektrum, der Baugruppe. Auch in einer digitalen Aufnahme (z.B. eine Fotografie) der Baugruppe sind einzigartige Merkmale enthalten. Dies können beispielsweise minimale Abweichungen der Position von Bauelementen selbst oder mehreren Bauelementen zueinander und von entsprechenden Fügestellen sein. Die digitale Aufnahme kann beispielsweise durch eine CCD Kamera bereitgestellt werden, die bereits in der Fertigungslinie vorhanden ist.

In einer weiteren Ausführungsform umfasst das Verfahren ein Auswählen des Teilbereichs der Aufnahme, sodass der Teilbereich ein oder mehrere Fügeverbindungen umfasst. Es hat sich gezeigt, dass Fügeverbindungen besonders einzigartige Muster von Merkmalen bilden. Dazu zählen sowohl Sinter- als auch Lötverbindungen. Das Auswählen eines Teilbereichs hat den Vorteil, dass nicht die gesamte Aufnahme weiterverarbeitet und/oder abgespeichert werden muss. Vorteilhaft wird der Teilbereich so gewählt, dass ein zentrales Bauelement ausgewählt wird. Wenn ein zentrales Bauelement gewählt wird, so ist es vorteilhaft, wenn das Bauelement eine im Verhältnis zu seinem Footprint große Fügefläche aufweist, da diese ein entsprechend einzigartiges und gut auswertbares Muster von Merkmalen zeigt. Es können Teilbereichs-Informationen hinsichtlich des Ortes des Teilbereichs im Datensatz hinterlegt werden. Die Auswahl des Teilbereichs kann dabei als eine weitere Sicherung gegen Nachahmer dienen, wenn der Teilbereich zufällig gewählt wird.

In einer weiteren Ausführungsform wird der Identifikationsdatensatz auf Basis zumindest einer Anzahl und/oder einer Anordnung und/oder einer Größe von Merkmalen zumindest einer der Fügeverbindungen erzeugt. Fügeverbindungen weisen Unregelmäßigkeiten auf, die sich hier zu Nutze gemacht werden. Diese Unregelmäßigkeiten sind bedingt z. B. durch Gaseinschlüsse, deren Form, Größe, Anzahl und Verteilung einzigartig für jede Fügeverbindung sind.

In einer weiteren Ausführungsform wird der Identifikationsdatensatz auf Basis von Gaseinschlüssen in Fügeverbindungen als Merkmale erzeugt. Es hat sich gezeigt, dass die Gaseinschlüsse besonders einzigartige Muster, d.h. Kombinationen von Merkmalen, bilden.

In einer weiteren Ausführungsform umfasst das Erzeugen des Identifikationsdatensatzes eine Kombination aus zumindest zwei verschiedenartigen Aufnahmen. Soll die Identifikation mit einer besonders hohen Zuverlässigkeit durchgeführt werden können, so ist es möglich mehrere Aufnahmen zu kombinieren, insbesondere zumindest eine Röntgenaufnahme und eine digitale Aufnahme, z. B. eine Aufnahme durch eine CCD/CMOS-Kamera im sichtbaren Spektrum. Die Aufnahmen können überlagert werden, um möglichst viele Merkmale zur Identifikation zu erhalten.

In einer weiteren Ausführungsform umfasst das Erzeugen des Identifikationsdatensatzes zumindest ein Berechnen eines Hashwertes zumindest eines Teilbereichs der Aufnahme. Prinzipiell gibt es die Möglichkeit übliche Hashwerte der Aufnahme zu erzeugen, wie bspw. SHA. Dieser Hashwert hat die Eigenschaft, bereits bei kleinsten Änderungen in der Aufnahme einen anderen Wert zu generieren. Dies wäre auch der Fall, wenn eine Prüf-Aufnahme von einer anderen Aufnahmevorrichtung (unterschiedlicher Röntgenapparat) aufgenommen wird. Es kann sich ein Perceptual-Hash-Verfahren empfehlen, das unempfindlicher gegenüber kleineren Schwankungen in der Aufnahmequalität ist und der eigentlichen Wahrnehmung der Merkmale angepasst ist, um Ähnlichkeiten herauszufinden. Derartige Verfahren werden beispielsweise Bildsuchen eingesetzt. Bekannte Verfahren sind hier bspw. pHash und Blockhash.io.

In einer weiteren Ausführungsform wird beim Erzeugen des Identifikationsdatensatzes zumindest eine Seriennummer der Baugruppe gespeichert. Die Seriennummer verknüpft weitere Daten, die beim Hersteller vorliegen mit dem Identifikationsdatensatz. So kann der Identifikationsdatensatz schnell und einfach weiteren Informationen zugeordnet werden und bereits eine erste Prüfung direkt an der Baugruppe vorgenommen werden.

Die Aufgabe wird weiterhin durch ein Verfahren zum Herstellen einer elektronischen Baugruppe gelöst, umfassend die Schritte:
- Bereitstellen eines Substrats mit Fügematerial,
- Bestücken zumindest eines elektronischen Bauelements,
- Fertigstellen zumindest einer Fügeverbindung zwischen dem elektronischen Bauelement und dem Substrat und
- Erzeugen eines Identifikationsdatensatzes nach einem erfindungsgemäßen Verfahren.
   So kann das erfindungsgemäße Verfahren direkt während der Produktion durchgeführt und der Identifikationsdatensatz erzeugt werden. Dies ist besonders effizient, vorhandene Inspektionsaufnahmen erzeugen des Identifikationsdatensatzes verwendet werden können.

Die Aufgabe wird weiterhin durch eine Verwendung eines Identifikationsdatensatzes gelöst, der nach einem erfindungsgemäßen Verfahren erzeugt wurde, als zumindest Teil eines kryptographischen Geheimnisses zur Authentisierung und/oder Verschlüsselung einer Kommunikation einer elektronischen Baugruppe. Die Verwendung von zumindest Teilen des Identifikationsdatensatzes ermöglicht das Erstellen von Geheimnissen zur Authentisierung und/oder Verschlüsselung direkt in der Produktion. Die Sicherheit der Baugruppen kann so erhöht werden.

Die Aufgabe wird weiterhin durch eine Verwendung eines Identifikationsdatensatzes erzeugt mit dem erfindungsgemäßen Verfahren als physical unclonable function.

Die Aufgabe wird weiterhin durch ein Verfahren zum Überprüfen einer elektronischen Baugruppe gelöst, umfassend:
- Bereitstellen eines Identifikationsdatensatzes für die Baugruppe,
- Bereitstellen einer Prüf-Aufnahme zumindest eines Teilbereichs der Baugruppe,
- Erzeugen eines Prüfdatensatzes auf Basis zumindest eines Teilbereichs der Prüf-Aufnahme und
- Vergleichen des Identifikationsdatensatzes mit dem Prüfdatensatz.

Das Erzeugen des Prüfdatensatzes kann analog zum Erzeugen des Identifikationsdatensatzes, idealerweise auf Basis desselben Algorithmus, erfolgen. Beispielsweise kann also aus der Prüf-Aufnahme durch Anwenden des Verfahrens zum Erzeugen eines Identifikationsdatensatzes der Prüf-Datensatz erzeugt werden. Werden die Aufnahmen direkt erstellt, so ist es möglich durch ein Bildvergleich, zum Beispiel ein Übereinanderlegen der Aufnahmen, eine Identifikation durchzuführen. Auch ein Erstellen eines Differenzbildes mit entsprechenden Algorithmen, die eventuelle Abweichungen hervorherben, kann hier durchgeführt werden.

In einer weiteren Ausführungsform wird zum Überprüfen der elektronischen Baugruppe der Teilbereich der Prüf-Aufnahme auf Basis von Teilbereichs-Informationen im Identifikationsdatensatz gewählt. So kann ein direkter Vergleich der Daten stattfinden.

Im Folgenden wird die Erfindung anhand der in den Figuren dargestellten Ausführungsbeispiele näher beschrieben und erläutert. Es zeigen:
- FIG 1: elektronische Baugruppe 100 im Querschnitt,
- FIG 2: eine Draufsicht einer elektronischen Baugruppe,
- FIG 3: eine Röntgen-Aufnahme einer elektronischen Baugruppe,
- FIG 4: eine weitere Röntgen-Aufnahme und
- FIG 5: schematisch das Erzeugen eines Identifikationsdatensatzes

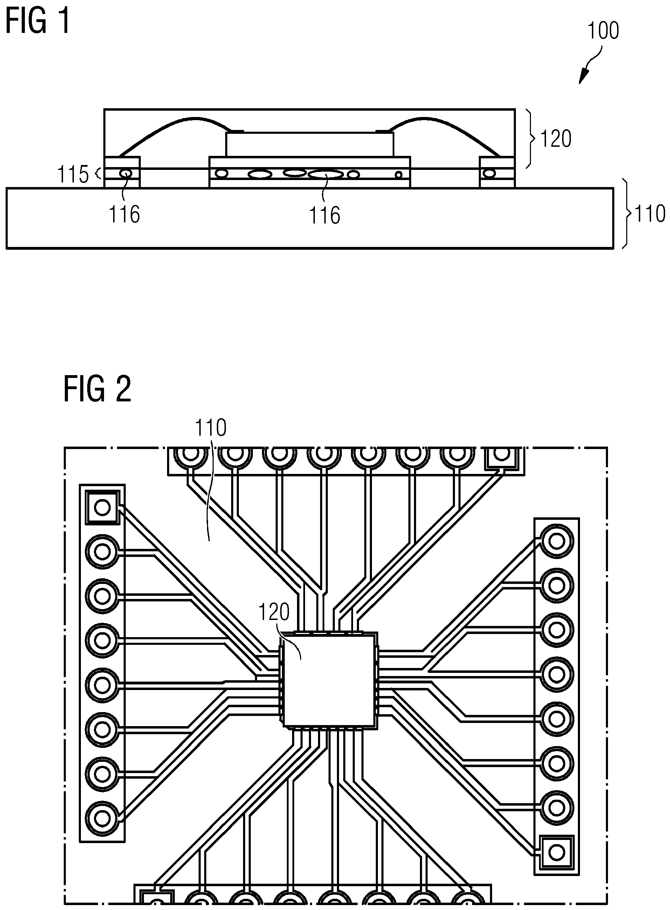

FIG 1 zeigt eine elektronische Baugruppe 100 im Querschnitt. Die Baugruppe 100 weist ein Substrat 110, eine Fügeverbindung 115 sowie ein elektronisches Bauelement 120 auf, wobei das elektronische Bauelemente 120 mittels der Fügeverbindung 115 an das elektronische Substrat 110 gefügt ist. Fügeverbindung 115 weist dabei kleinere Gaseinschlüsse 116 auf. Die Gaseinschlüsse 116 sind dabei einzigartige Merkmale M115, die im weiteren Verfahren zum Erzeugen eines Identifikationsdatensatzes verwendet werden können.

FIG 2 zeigt eine Draufsicht der elektronischen Baugruppe 100 aus FIG 1. Das elektronische Bauelement 120 deckt in diesem Fall die Fügeverbindung 115 ab, sodass diese hier nicht zu sehen ist. Als Unterscheidungsmerkmale können aber trotzdem minimale Abweichungen der Montage des elektronischen Bauelements dienen.

Wird nun während der Fertigung von einem zentralen Baustein, hier das elektronische Bauelement 120, ein Röntgenbild aufgenommen und speichert es mit der Seriennummer der Baugruppe ab, kann später jederzeit nachgewiesen werden, ob eine fragliche Baugruppe aus dem Feld tatsächlich der gefertigten Baugruppe entspricht. Es kann außerdem mit einiger Sicherheit bestimmt werden, ob diese Baugruppe hardwaremäßig modifiziert wurde, da ein entsprechender (nachfolgender und zusätzlicher) Lötprozess zu einem anderen Muster führen würde.

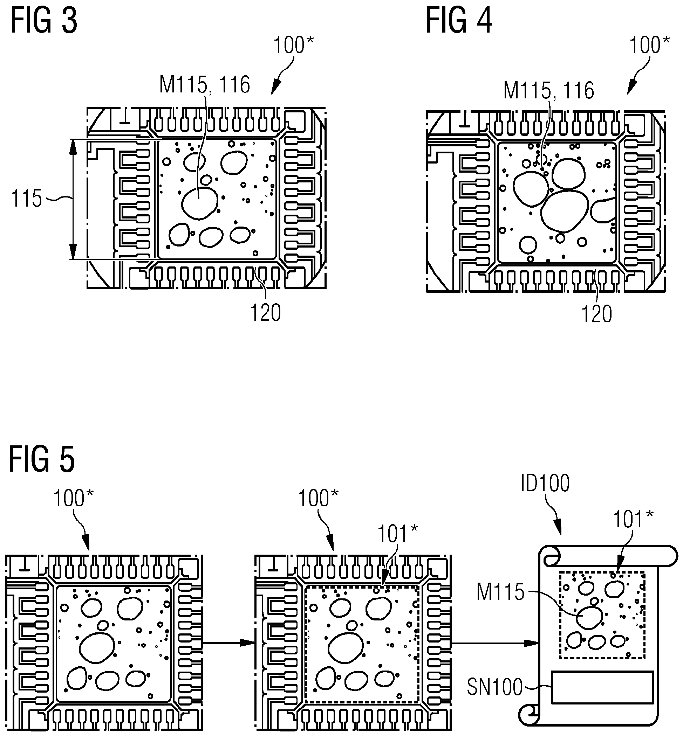

FIG 3 zeigt eine Röntgen-Aufnahme 100* einer Baugruppe 100 mit einem Bauelement 120, das aber transparent ist, da die Röntgenaufnahme 100* vor allem die Fügeverbindung darstellt. Als Merkmal M115 sind hier Gaseinschlüsse 116 in der Fügeverbindung 115 zu sehen. Die Gaseinschlüsse 116 haben dabei ein unverwechselbares Muster gebildet, dass sich durch den Fügeprozess zufällig einstellt und daher nicht kopierbar ist.

Als Vergleich dazu zeigt FIG 4 eine weitere Röntgen-Aufnahme 100* mit einem gleichartigen Bauelement 120, die unter gleichartigen Prozessbedingungen gelötet wurden. Gut zu erkennen ist ein Muster der Gaseinschlüsse 116, was sich von Bauelement 120 in FIG 3 zu Bauelement 120 in FIG 4 unterscheidet. Durch "Übereinanderlegen" oder einfaches Vergleichen der Merkmale M115, in diesem Fall also der Gaseinschlüsse 116, kann man bereits mit dem Auge recht sicher sagen, dass es sich bei den Bauelementen 120 nicht um ein- und dieselben Bauelemente 120 handelt und somit ebenso wenig um dieselbe Baugruppe 100. Der Vergleich kann durch die gemäß einer Ausgestaltung der Erfindung beschriebenen Hash-Verfahren komplett automatisiert werden.

FIG 5 zeigt eine Aufnahme 100*, wie sie aus FIG 3 und FIG 4 bekannt ist. Um eine möglichst aussagekräftige Basis für den Identifikationsdatensatz ID100 zu erhalten, wird nun ein Teilbereich 101* der Aufnahme 100* ausgewählt. Im vorliegenden Fall wird der Teilbereich gewählt, der eine Fügefläche 115 mit einem aussagekräftigen Muster von Merkmalen M115 aufweist. Das Auswählen des Teilbereichs 101* kann dabei durch den Entwickler der Baugruppe 100 durchgeführt werden. Es ist ebenso denkbar, dass ein Algorithmus auf Basis von Parametern der Baugruppe 100, zum Beispiel der Größe von Fügeverbindungen 115 oder der Merkmale M115, automatisiert eine Auswahl des Teilbereichs 101* durchführt.

In einem weiteren Schritt wird der Identifikationsdatensatz ID100 fertiggestellt, in diesem Fall wird dazu der Teilbereich 101* der Aufnahme 100*, der aussagekräftige Merkmale M115 aufweist, in Verbindung mit einer Seriennummer SN100 der Baugruppe im Identifikationsdatensatz ID100 gespeichert. In einer alternativen Ausführungsform kann alternativ oder ergänzend zum Teilbereich 101* noch ein Hashwert des Teilbereichs erstellt und im Identifikationsdatensatz ID100 gespeichert werden.

Zusammenfassend betrifft die Erfindung ein computerimplementiertes Verfahren zum Erzeugen eines Identifikationsdatensatzes (ID100) für eine elektronische Baugruppe (100), wobei die Baugruppe (100) zumindest ein Substrat (110), zumindest eine Fügeverbindung (115) und zumindest ein elektronisches Bauelement (120) aufweist. Um ein vereinfachtes Verfahren zum Erzeugen eines sicheren Identifikationsdatensatzes (ID100) für elektronische Baugruppen (100) anzugeben umfasst das Verfahren die Schritte:
- Bereitstellen einer Aufnahme (100*) zumindest eines Teilbereichs der Baugruppe (100),
- Erzeugen des Identifikationsdatensatzes (ID100) auf Basis zumindest eines Teilbereichs (101*) der Aufnahme (100*).
   Die Erfindung betrifft weiterhin ein Verfahren zum Herstellen einer elektronischen Baugruppe (100), eine Verwendung eines Identifikationsdatensatzes (ID100) und ein Verfahren zum Überprüfen einer elektronischen Baugruppe (100).

### Bezugszeichen

- 100: elektronische Baugruppe
- 110: Substrat
- 115: Fügeverbindung
- 116: Gaseinschluss
- 120: elektronisches Bauelement

- 100*: Aufnahme der Baugruppe
- 101*: Teilbereich der Aufnahme

- M115: Merkmal der Fügeverbindung

- ID100: Identifikationsdatensatz
- SN100: Seriennummer der elektronischen Baugruppe

## Patentansprüche

1. Computerimplementiertes Verfahren zum Erzeugen eines Identifikationsdatensatzes (ID100) für eine elektronische Baugruppe (100), wobei die Baugruppe (100) zumindest ein Substrat (110), zumindest eine Fügeverbindung (115) und zumindest ein elektronisches Bauelement (120) aufweist, umfassend die Schritte:
- Bereitstellen einer Aufnahme (100*) zumindest eines Teilbereichs der Baugruppe (100),
- Erzeugen des Identifikationsdatensatzes (ID100) auf Basis zumindest eines Teilbereichs (101*) der Aufnahme (100*).

2. Verfahren nach Anspruch 1, wobei das Bereitstellen der Aufnahme (100*) ein Bereitstellen einer Röntgen-Aufnahme der Baugruppe (100) umfasst.

3. Verfahren nach einem der vorhergehenden Ansprüche, wobei das Bereitstellen der Aufnahme (100*) ein Bereitstellen einer digitalen Aufnahme der Baugruppe (100) umfasst.

4. Verfahren nach einem der vorhergehenden Ansprüche, umfassend ein Auswählen des Teilbereichs (101*) der Aufnahme (100*), sodass der Teilbereich (101*) ein oder mehrere Fügeverbindungen (115) umfasst.

5. Verfahren nach einem der vorhergehenden Ansprüche, wobei der Identifikationsdatensatz (ID100) auf Basis zumindest einer Anzahl und/oder einer Anordnung und/oder einer Größe von Merkmalen (M115) zumindest einer der Fügeverbindungen (115) erzeugt wird.

6. Verfahren nach Anspruch 5, wobei der Identifikationsdatensatz (ID100) auf Basis von Gaseinschlüssen (116) in Fügeverbindungen (115) als Merkmale (M115) erzeugt wird.

7. Verfahren nach einem der vorhergehenden Ansprüche, wobei das Erzeugen des Identifikationsdatensatzes (ID100) eine Kombination aus zumindest zwei verschiedenartigen Verfahren zum Bereitstellen der Aufnahme (100*) umfasst.

8. Verfahren nach einem der vorhergehenden Ansprüche, wobei das Erzeugen des Identifikationsdatensatzes (ID100) zumindest ein Berechnen eines Hashwertes zumindest eines Teilbereichs (101*) der Aufnahme (100*).

9. Verfahren nach einem der vorhergehenden Ansprüche, wobei beim Erzeugen des Identifikationsdatensatzes (ID100) zumindest eine Seriennummer (SN100) der Baugruppe (100) gespeichert wird.

10. Verfahren zum Herstellen einer elektronischen Baugruppe (100) umfassend die Schritte:
- Bereitstellen eines Substrats (110) mit Fügematerial,
- Bestücken zumindest eines elektronischen Bauelements (120),
- Fertigstellen zumindest einer Fügeverbindung (120) zwischen dem elektronischen Bauelement (120) und dem Substrat (110) und
- Erzeugen eines Identifikationsdatensatzes (ID100) nach einem Verfahren nach einem der vorhergehenden Ansprüche.

11. Verwendung eines Identifikationsdatensatzes (ID100) erzeugt nach einem der Ansprüche 1 bis 9, zumindest als Teil eines kryptographischen Geheimnisses zur Authentisierung und/oder Verschlüsselung einer Kommunikation einer elektronischen Baugruppe.

12. Verwendung eines Identifikationsdatensatzes (ID100) erzeugt nach einem der Ansprüche 1 bis 9, als physical unclonable function.

13. Verfahren zum Überprüfen einer elektronischen Baugruppe (100), umfassend:
- Bereitstellen eines Identifikationsdatensatzes (ID100) gemäß einem der Anspruche 1 bis 9 für die Baugruppe (100),
- Bereitstellen einer Prüf-Aufnahme zumindest eines Teilbereichs der Baugruppe (100),
- Erzeugen eines Prüfdatensatzes auf Basis zumindest eines Teilbereichs der Prüf-Aufnahme und
- Vergleichen des Identifikationsdatensatzes (ID100) mit dem Prüfdatensatz.

14. Verfahren nach Anspruch 12, umfassend ein Auswählen des Teilbereichs der Prüf-Aufnahme auf Basis von Teilbereichs-Informationen im Identifikationsdatensatz (ID100).
